## Europäisches Patentamt
## European Patent Office
## Office européen des brevets

(11) Veröffentlichungsnummer: **0 020 857**
**B1**

(12) **EUROPÄISCHE PATENTSCHRIFT**

(45) Veröffentlichungstag der Patentschrift: **13.06.84**

(21) Anmeldenummer: **80101185.9**

(22) Anmeldetag: **08.03.80**

(51) Int. Cl.³: **H 01 L 21/60, H 01 L 21/48 //H01L23/48**

(54) **Verfahren und Vorrichtung zur Herstellung eines planaren Halbleiterbauelements.**

(30) Priorität: **09.06.79 DE 2923440**

(43) Veröffentlichungstag der Anmeldung:
**07.01.81 Patentblatt 81/1**

(45) Bekanntmachung des Hinweises auf die Patenterteilung:
**13.06.84 Patentblatt 84/24**

(84) Benannte Vertragsstaaten:
**DE FR GB IT NL**

(56) Entgegenhaltungen:
**DE - A - 1 514 561**
**DE - A - 1 627 649**
**DE - B - 1 439 349**
**DE - B - 2 546 443**
**FR - A - 2 179 102**
**GB - A - 1 275 343**
**GB - C - 1 026 300**
**US - A - 3 982 317**

**WESTERN ELECTRIC-TECHNICAL DIGEST, No. 35, Juli 1974, New York, USA D.B. GORDON et al. "Method of bonding silicon chips to lead frames", Seiten 27-28**

(73) Patentinhaber: **Deutsche ITT Industries GmbH Hans-Bunte-Strasse 19 Postfach 840 D-7800 Freiburg (DE)**
(84) **DE**
(73) Patentinhaber: **ITT INDUSTRIES INC. 320 Park Avenue New York, NY 10022 (US)**
(84) **FR GB IT NL**

(72) Erfinder: **Winkler, Kurt Neumattstrasse 9 D-7809 Denzlingen (DE)**
Erfinder: **Heitzler, Viktor Schlossweg 4 D-7801 Umkirch (DE)**
Erfinder: **Albrecht, Andreas Riedhofstrasse 11 D-7835 Heimbach (DE)**

(74) Vertreter: **Stutzer, Gerhard, Dr. Deutsche ITT Industries GmbH Patent- und Lizenzabteilung Hans-Bunte-Strasse 19 Postfach 840 D-7800 Freiburg (DE)**

(56) Entgegenhaltungen:
**WESTERN ELECTRIC-TECHNICAL DIGEST, Nr. 44, Oktober 1976, New York, USA D.D. DEMUZIO et al. "Soldering of leads to semiconductor chips", Seiten 15-16**

## Beschreibung

Die Erfindung betrifft ein Verfahren zum Herstellen eines planaren Halbleiterbauelements nach dem Oberbegriff des Anspruchs 1 sowie eine Vorrichtung zur Durchführung dieses Verfahrens.

Bei der automatischen Massenmontage von Halbleiterkörpern wird ein metallisches Montageband benützt, das entsprechend den zu befestigenden Halbleiterkörpern und der angestrebten Verwendung so vorgestanzt ist, daß die montierten Halbleiterkörper und deren zugehörige Trägerteile vereinzelt werden können. Dabei werden die Halbleiterkörper zunächst durch Legieren, Löten oder Kleben auf den dafür vorgesehenen Bereichen des Montagebandes elektrisch leitend befestigt.

Zum Kontaktieren der auf der Vorderseite der Halbleiterkörper angeordneten Kontaktflecke mit den äußeren Zuleitungen des Gehäuses verwendet man dünne Gold-, Silber- oder Aluminiumdrähte. Neben dem Ultraschall-Bondverfahren bedient man sich heute hauptsächlich des Thermokompressions-Bondverfahrens, vgl. I. Ruge "Halbleitertechnologie", Berlin 1975, Seite 287. Das Thermokompressions-Bondverfahren wird in Form des sogenannten Nagelkopf-Bondverfahrens bei der Herstellung von Halbleiterbauelementen verbreitet angewendet. Dabei wird ein Verbindungsdraht mittels einer Wasserstoffflamme durchtrennt, wobei sich eine kleine Kugel, der Nagelkopf, bildet, die mittels einer Führungskapillare auf die Kontaktierungsstellen gedrückt wird. Der Durchmesser der Verbindungsdrähte liegt dabei im Bereich von 10 bis 50 $\mu$m.

Die Kontaktierungsstelle der Verbindungsdrähte mit den Kontaktflecken eines Halbleiterkörpers bzw. mit den äußeren Zuleitungen muß zwei Bedingungen erfüllen; zum einen muß sie mechanisch fest und zum anderen elektrisch gut leitend sein. Dies erfordert in beiden Fällen eine innige Verbindung der aus verschiedenen Stoffen bestehenden Teile. Ferner ist es wichtig, daß diese Verbindung beim automatischen Ablauf innerhalb von Bruchteilen einer Sekunde hergestellt werden kann. Das Thermokompressions-Bondverfahren nutzt dazu die Eigenschaft aus, daß bestimmte Metalle, sofern sie keine störenden Oberflächenschichten bilden, bei unter dem eutektischen Punkt liegenden Temperaturen und bei gleichzeitiger Einwirkung von Drücken, die niedriger als die für das Kaltschweißverfahren erforderlichen Drücke sind, beim Zusammenpressen an ihrer Grenzschicht eine Verbindung hoher mechanischer Festigkeit und guter elektrischer Leitfähigkeit bilden. Durch das Nagelkopf-Verfahren werden die oben genannten Anforderungen derart gut erfüllt, daß es weit verbreitet ist. Von den verschiedenen Möglichkeiten, mittels Thermokompression Kontakte herzustellen, hat sich der Aluminium-Gold-Kontakt als die sicherste Verbindung herausgestellt.

Aus der DE—OS 15 14 561 ist ein Verfahren bekannt, das die serienmäßige Herstellung von Legierungshalbleiterbauelementen betrifft und bei denen mindestens eine bereits einlegierte Elektrode des Bauelementsystems unter Ausnutzung der reduzierenden Eigenschaften des Wasserstoffs mit der Stromzuführung verlötet wird. Dabei werden nach dem Aufbau des Bauelementsystems auf entsprechende Sockel durch Anschweißen einer Elektrode des Systems an einen Zuführungsdraht des Sockels mindestens eine andere Elektrode, vornehmlich alle anderen Elektroden mit den Stromzuführungsdrähten in Berührung gebracht und unmittelbar im Anschluß daran durch reduzierendes Einwirkenlassen von mindestens einer Wasserstoffflamme mit letzteren verlötet.

Neben der Herstellung einer Verbindung zwischen den Golddrähten und den auf der Halbleiteroberfläche befindlichen Kontaktflecken ist aber auch die Herstellung einer innigen Verbindung der Golddrähte mit den äußeren Zuleitungen erforderlich. In diesem Zusammenhang ist in der DE—AS 14 39 349 als Material für das Montageband bzw. die äußeren Zuleitungen eine Eisen-Kobalt-Nickel-Legierung angegeben, die zur Erzielung einer guten Kontaktierung mit den Verbindungsdrähten zu vergolden ist. Trotz der Vergoldung ist diese Legierung jedoch ein schlechter thermischer und elektrischer Leiter. Aus diesem Grund verwendet man praktisch ausschließlich ein in der DE—AS 25 46 443 beschriebenes Montageband aus Kupfer. Kupfer hat zwar weitaus bessere thermische und elektrische Eigenschaften als die erwähnte Eisen- Kobalt- Nickel-Legierung, seine Oberfläche ist jedoch immer mehr oder weniger stark oxidiert. Da aber bei der Herstellung der Verbindungen zwischen dem Montageband und den Verbindungsdrähten bzw. dem Halbleiterkörper die Oberflächenverhältnisse, insbesondere deren Reinheit, eine große Rolle spielen, weil sonst kein ausreichend fester Kontakt zustande kommt, ist ein Schutz der Kupferoberfläche unumgänglich. Deshalb ist in der zuletzt genannten DE—AS auch für das kupferne Montageband eine Gold- oder Silberplattierung vorgeschrieben. Auch das in der GB—PS 10 26 300 beschriebene Montageband für Halbleiterkörper ist mit Gold plattiert.

Aus der US—PS 39 82 317 ist ein Verfahren zur kontinuierlichen Befestigung von Transistoren auf einem Montageband (lead frame) bekannt, bei dem dieses zum Schutz gegen Korrosion und zur Bereitstellung leicht lötbarer Oberflächen in den Anschlußbereichen plattiert oder Zinnbeschichtet ist.

Eine Plattierung mit Gold oder Silber ist jedoch im Hinblick auf die äußerst scharf kalkulierten Halbleiterbauelementpreise, die immer mehr fallen, während gleichzeitig die Gold- und Silberpreise steigen, wirtschaftlich nicht mehr tragbar. Außerdem ist die Plattierung ein weiterer kostenerhöhender Arbeitsvorgang bei der Herstellung des Montagebandes.

Hier will die Erfindung Abhilfe schaffen. Die Erfindung, wie sie in den Ansprüchen gekennzeichnet ist, löst somit die Aufgabe, ein Verfahren zum Herstellen eines planaren Halbleiterbauelements nach dem Oberbegriff des Anspruchs 1 anzugeben, welches kostensparender, also ohne eine Plattierung des Montagebandes und insbesondere ohne Gold- oder Silberplattierung auskommt. Darüberhinaus soll eine Vorrichtung zur Durchführung des Verfahrens angegeben werden. Die Erfindung geht von der überraschenden Erkenntnis aus, daß es im Gegensatz zu der im Stand der Technik einhellig vertretenen Ansicht möglich ist, bei einem Halbleiterbauelement auf die metallische Zwischenschicht zwischen den Anschlußdrähten und dem Montageband, also auf dessen Plattierung zu verzichten. Die Erfindung beschreibt demnach ein Verfahren zum Herstellen eines planaren Halbleiterbauelements, bei dem ein Silicium-Halbleiterkörper zur Massenfertigung mit seiner Rückseite auf einem die äußeren Zuleitungen enthaltenden Montageband, das insbesondere Kupfer oder eine Kupferlegierung enthält, elektrisch leitend verbunden wird und bei dem die auf der Vorderseite des Halbleiterkörpers liegende Kontaktflecken über Verbindungsdrähte an den äußeren Zuleitungen angeschlossen werden. Die aus Kupfer oder einer Kupferlegierung bestehende Oberfläche des Montagebandes wird dabei unmittelbar vor dem Befestigen des Halbleiterkörpers wie auch der Verbindungsdrähte reduktiv gereinigt, das Befestigen des Halbleiterkörpers erfolgt durch Kleben, Löten oder Legieren, das Befestigen der Verbindungsdrähte durch Thermokompression. Man erhält also auf diese Weise ein planares Halbleiterbauelement, bei dem die Verbindungsdrähte auf der aus Kupfer oder einer Kupferlegierung bestehenden Oberfläche des Montagebandes direkt kontaktiert sind und bei dem die einzelnen Halbleiterkörper ebenfalls direkt, also plattierungslos, auf der aus Kupfer oder einer Kupferlegierung bestehenden Oberfläche des Montagebandes befestigt sind.

Die Erfindung wird nun anhand der Figuren der Zeichnung näher erläutert.

Fig. 1 zeigt schematisch im Schnitt ein Halbleiterbauelement, nämlich einen Transistor, hergestellt nach der Erfindung,

Fig. 2 zeigt schematisch eine Vorrichtung zur Befestigung des Halbleiterkörpers nach Fig. 1 auf dem Montageband und

Fig. 3 zeigt schematisch eine Vorrichtung zur Kontaktierung der Verbindungsdrähte.

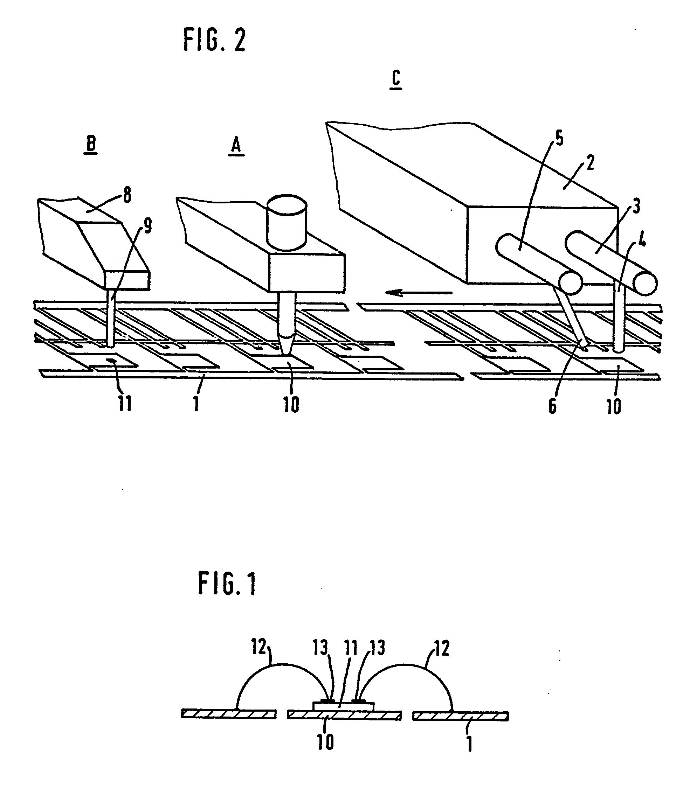

Der Siliciumhalbleiterkörper des planaren Halbleiterbauelements, hergestellt nach der Erfindung ist bei der Massenfertigung mit seiner Rückseite auf einem die äußeren Zuleitungen enthaltenden Montageband, das insbesondere Kupfer- oder eine Kupferlegierung enthält, elektrisch leitend kontaktiert. Seine auf der Vorderseite liegenden Kontaktflecke sind über Verbindungsdrähte an den äußeren Zuleitungen angeschlossen. Dabei sind der Halbleiterkörper 11 (siehe Fig. 1) und die Verbindungsdrähte 12, die zweckmäßigerweise aus Gold, Silber oder Aluminium bestehen können, mit der aus Kupfer oder einer Kupferlegierung bestehenden Oberfläche des Montagebandes 1 bzw. der Zuleitungen direkt, d.h. ohne metallische Zwischenschicht, kontaktiert.

Fig. 1 zeigt im Schnitt schraffiert das Montageband 1 mit der Trägerzuleitung 10 für den Halbleiterkörper 11, der mit seiner Rückseite darauf befestigt ist. Seine Kontaktflecke 13 sind über die Verbindungsdrähte 12 mit den Zuleitungen des Montagebandes 1 kontaktiert. Diese Kontaktierung geschieht jeweils direkt mit der kupfernen Oberfläche des Montagebandes 1.

In Fig. 2 ist perspektivisch das vorgestanzte Montageband 1 gezeigt, das in der Vorrichtung C unter dem Bauteil 2 in Taktschritten und in Pfeilrichtung vorbeigeführt wird. Das Bauteil 2 enthält das Rohr 3 mit der senkrecht daran befestigten Kanüle 4 und das Rohr 5 mit der schräg daran befestigten Kanüle 6. Die Auslaßöffnungen der beiden Kanülen 4, 6 liegen knapp über der Oberfläche des Montagebandes 1 im Bereich des zu kontaktierenden Halbleiterkörpers 11, also im Bereich der Trägerzuleitung 10.

Die Kleberaufbring vorrichtung A ist wenige Taktschritte vom Bauteil 2 weiter angeordnet und bringt eine kleine Leitklebermenge auf die Trägerzuleitung 10 auf. Wieder wenige Taktschritte in Pfeilrichtung weiter ist die Aufsetzvorrichtung B für die Halbleiterkörper 11 angeordnet, deren Schwenkarm 8 mit der Saugpipette 9 die vereinzelten Halbleiterkörper 11 vom Wafer abnimmt und auf das Montageband 1 aufsetzt.

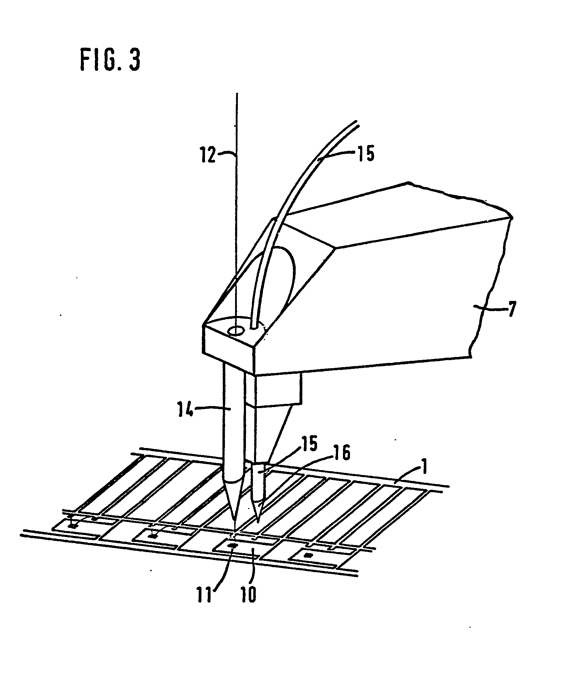

Fig. 3 zeigt schematisch die Kontaktierungsstation für die Verbindungsdrähte 12 der auf dem Montageband 1 aufgeklebten Halbleiterkörper 11. An der Schwenkhalterung 7 ist die Kapillare 14 für den jeweiligen Verbindungsdraht 12 befestigt. Entlang der Kapillare 14 verläuft das in der Kanüle 16 endende Gaszuführungsrohr 15, wobei deren Gasaustrittsöffnung in der Höhe der Öffnung der Kapillare 14 liegt. Bei Betrieb der Anordnung nach Fig. 2 läuft das vorgestanzte Montageband mit seiner Oberfläche aus Kupfer oder einer Kupferlegierung von einer Rolle ab und wird zunächst an einer feinen, am Ende der Kanüle 4 brennenden Wasserstoffflamme vorbeigeführt, die diejenigen Bereiche der Trägerzuleitungen 10 überstreicht, auf denen die einzelnen Halbleiterkörper 11 aus Silicium befestigt werden sollen. Nach dem Passieren der Wasserstoffflamme werden die Trägerzuleitungen 10 durch Anblasen mit einem Stickstoffstrom aus der Kanüle 6 gekühlt. Unmittelbar danach werden die einzelnen Halbleiterkörper 10 in üblicher Weise unter Verwendung eines Epoxidleitklebers auf die so vorbereiteten Trägerzuleitungen 10 des Montagebandes 1 aufgeklebt und anschließend der Kleber durch Temperatureinwirkung gehärtet. Die Halbleiterkörper können selbstverständlich auch durch Löten oder Legieren auf dem Montageband befestigt werden.

Das Montageband 1 mit den bereits darauf befestigten Halbleiterkörpern 11 wird dann einer Kontaktierungsstation nach Fig. 3 zugeführt, mittels der nach dem Nagelkopfverfahren die, vorzugsweise aus Gold bestehenden, Verbindungsdrähte 12 angebracht werden. Die Zuführung der Goldverbindungsdrähte erfolgt in üblicher Weise über die am Schwenkarm 7 angebracht Kapillare 14, wobei durch das Gaszuführungsrohr 15 und die Kanüle 16 eine Wasserstoffflamme gespeist wird, die so neben der Öffnung der Kapillare 14 angeordnet ist, daß die Wasserstoffflamme unmittelbar vor dem Kontaktieren der Zuleitungen mit den Verbindungsdrähten die Oberfläche der Zuleitungen überstreicht. Die Anpreßkraft für die Golddrähte liegt dabei um ca. 50% niedriger als bisher üblich.

Die Wasserstoffflammen (Länge ca. 5 mm, lichte Weite der Kanülen 4, 16 ca. 0,1 bis 0,3 mm) wirken jeweils nur kurz ein, nämlich während etwa 1/5 bis 1/10 der für die Kontaktierung eines Kontaktflecks eines Halbleiterkörpers erforderlichen Arbeitstaktzeit, da sie durch entsprechende kurzzeitige Bewegung der Kanülen an den Kontaktierungsstellen lediglich vorbeiwischen.

Anstatt einer Wasserstoffflamme kann in manchen Fällen auch das Anblasen mit einem Wasserstoffstrom ausreichen. Die Kontaktierung des Halbleiterkörpers und der Verbindungsdrähte kann durch die Verwendung von Ultraschall unterstützt werden.

Das Verfahren zur Herstellung der planaren Halbleiterbauelement nach der Erfindung ermöglicht also nicht nur die Verwendung von unplattierten Montagebändern, es bringt auch den Vorteil der Anpreßkraftverringerung bei der Thermokompression, was zur Schonung der Halbleiterkörper beiträgt. Überraschenderweise verbessert das Vorbeiwischen der Wasserstoffflamme an den Aluminiumkontaktflecken auch den Gold-Aluminium-Kontakt.

**Patentansprüche**

1. Verfahren zum Herstellen eines planaren Halbleiterbauelements, bei dem ein Silicium-Halbleiterkörper zur Massenfertigung mit seiner Rückseite auf einem die äußeren Zuleitungen enthaltenden Montageband, das insbesondere Kupfer oder eine Kupferlegierung enthält, elektrisch leitend verbunden wird und bei dem die auf der Vorderseite des Halbleiterkörpers liegenden Kontaktflecken über Verbindungsdrähte an den äußeren Zuleitungen angeschlossen werden, dadurch gekennzeichnet, daß die aus Kupfer oder einer Kupferlegierung bestehende Oberfläche des Montagebandes (1) unmittelbar vor dem Befestigen des Halbleiterkörpers (11) wie auch der Verbindungsdrähte (12) reduktiv gereinigt wird und das Befestigen der Verbindungsdrähte (12) an den kontaktflecken (13) und am Montageband durch Thermokompression erfolgt.

2. Verfahren nach Anspruch 1, dadurch gekennzeichnet, daß die reduktive Reinigung in einer Wasserstoffatmosphäre durchgeführt wird.

3. Verfahren nach Anspruch 1, dadurch gekennzeichnet, daß die reduktive Reinigung mittels einer Wasserstoffflamme erfolgt.

4. Verfahren nach einem der Ansprüche 1 bis 3, dadurch gekennzeichnet, daß das Befestigen des Halbleiterkörpers (11) auf dem Montageband (1) durch Kleben, Löten oder Legieren erfolgt.

5. Verfahren nach einem der Ansprüche 2 bis 4, gekennzeichnet durch zusätzliche Verwendung von Ultraschall während des Befestigens und Kontaktierens.

6. Verfahren nach einem der Ansprüche 1 bis 5, dadurch gekennzeichnet, daß ein mit mehreren fingerartigen Zuleitungen versehenes Montageband (1) an einer Wasserstoffflamme vorbeigeführt wird, daß unmittelbar anschließend die Rückseite des Halbleiterkörpers (11) mit der dafür vorgesehenen Fläche einer Zuleitung durch Kleben elektrisch leitend verbunden wird und die weiteren fingerartigen Zuleitungen sowie die Aluminiumkontaktflecke (13) des Halbleiterkörpers (11) nacheinander erneut einer Wasserstoffflamme ausgesetzt und unmittelbar danach Golddrähte durch Thermokompression daran angebracht werden.

7. Vorrichtung zur Durchführung eines Verfahrens nach einem der Ansprüche 1 bis 6, bei dem das Montageband einer Klebeaufbringvorrichtung sowie einer einen Schwenkarm mit Saugpipette enthaltenden Aufsetzvorrichtung für die Halbleiterkörper taktweise zugeführt wird, dadurch gekennzeichnet, daß in einer einige Taktschritte vor der Kleberaufbringvorrichtung (A) liegenden Vorrichtung (C) ein Bauteil (2) angeordnet ist, daß ein Rohr (3) mit einer senkrecht angeordneten Kanüle (4) und ein Rohr (5) mit einer schräg angeordneten Kanüle (6) trägt, wobei die beiden Kanülen (4, 6) knapp über der Oberfläche des vorbeilaufenden Montagebandes (1) im Bereich des zu kontaktierenden Halbleiterkörpers (11) enden.

8. Vorrichtung zur Durchführung des Verfahrens nach einem der Ansprüche 1 bis 7, bei dem das Montageband einer Kontaktierungsvorrichtung taktweise zugeführt wird und ein Schwenkarm eine auf das Montageband gerichtete, den Verbindungsdraht führende Kapillare trägt, gekennzeichnet durch ein entlang der Kapillare (14) verlaufendes und in einer Kanüle (16) in Höhe der Öffnung der Kapillare (14) endendes Gasführungsrohr (15).

9. Vorrichtung nach den Ansprüchen 7 und 8 zur Durchführung des Verfahrens nach Anspruch 6, dadurch gekennzeichnet daß in Bewegungsrichtung des Montagebandes (1) zunächst die Vorrichtung (C) mit der senkrechten (4) und der schrägen Kanüle (6), dann die Kleberaufbringvorrichtung (A) und schließlich die Aufsetzvorrichtung (B) im Abstand von jeweils möglichst wenigen Taktschritten angeordnet sind.

10. Planares Halbleiterbauelement, hergestellt nach einem der Ansprüche 1 bis 4, dadurch gekennzeichnet, daß der Halbleiterkörper (11) und die Verbindungsdrähte (12) mit der aus Kupfer oder einer Kupferlegierung. bestehenden Oberfläche des Montagebandes (1) bzw. der Zuleitungen direkt kontaktiert sind.

## Revendications

1. Procédé de réalisation d'un composant semiconducteur à structure plane, dans lequel, pour une fabrication en grande série, un corps semiconducteur au silicium est, par sa face arrière, lié et électriquement relié à une bande de montage comportant en particulier du cuivre ou un alliage de cuivre et contenant les conducteurs d'amenée extérieurs, et dans lequel les surfaces de contact se trouvant sur la face avant du corps semiconducteur sont raccordés par des fils de liaison, aux conducteurs d'amenée extérieurs, caractérisé en ce que la surface de la bande de montage (1), faite de cuivre ou d'un alliage de cuivre, est, immédiatement avant la fixation du corps semiconducteur (11), ainsi que des fils de liaison (12), soumise à un nettoyage réducteur et en ce que la fixation des fils de liaison 12 s'effectue par thermocompression sur les points de contact (13) et sur la bande de montage.

2. Procédé selon la revendication 1, caractérisé en ce que le nettoyage réducteur est effectué dans une atmosphère d'hydrogène.

3. Procédé selon la revendication 1, caractérisé en ce que le nettoyage réducteur s'effectue au moyen d'une flamme d'hydrogène.

4. Procédé selon l'une quelconque des revendications 1 à 3, caractérisé en ce que la fixation du corps semiconducteur (11) sur la bande de montage (1) est effectuée par collage, soudage ou alliage.

5. Procédé selon l'une quelconque des revendications 2 à 4, caractérisé par l'emploi supplémentaire d'ultrasons pendant la fixation et la réalisation des connexions.

6. Procédé selon l'une quelconque des revendications 1 à 5, caractérisé en ce qu'une bande de montage dotée de plusieurs conducteurs d'amenée en forme de doigts passe devant une flamme d'hydrogène en ce que la face arrière dur corps semiconducteur (11) est immédiatement après cela liée et électriquement reliée, par collage, à la surface d'un conducteur prévu à cette fin, et en ce que les autres conducteurs d'amenée en forme de doigts ainsi que les points de contact en aluminium (13) du corps semiconducteur (11) sont successivement exposés à une flamme d'hydrogène après quoi les fils d'or y sont aussitôt connectés par thermocompression.

7. Dispositif de mise en oeuvre d'un procédé selon les revendications 1 à 6, dans lequel la bande de montage est amenée, par cycles successifs, à un dispositif d'apport de colle ainsi qu'à un dispositif de mise en place des corps semiconducteurs, lequel comporte un bras pivotant avec pipette d'aspiration, caractérisé en ce que, dans un dispositif (C) se trouvant à quelques pas en amont du dispositif d'apport de colle (A), est agencé un module (2) qui porte un tube (3) avec une aiguille (4) agencée verticalement et un tube (5) avec une aiguille (6) agencée obliquement, les deux aiguilles (4, 6) se terminant juste au-dessus de la surface de la bande de montage (1) qui défile, dans la région du corps semiconducteur (11) à connecter.

8. Dispositif de mise en oeuvre selon l'une des revendications 1 à 7, dans lequel la bande de montage est amenée, par cycles successifs, à un dispositif de connexion, et un bras pivotant porte un capillaire dirigé vers la bande de montage et guidant le fil de connexion, caractérisé par un tube d'amenée de gaz (15) longeant le capillaire (14) et se terminant dans une aiguille (16) à la hauteur de l'ouverture du capillaire (14).

9. Dispositif selon les revendications 7 et 8, pour mettre en oeuvre le procédé selon la revendication 6, caractérisé en ce que, dans la direction du mouvement de la bande de montage 1, sont agencés en premier le dispositif (C) avec l'aiguille verticale (4) et l'aiguille oblique (6), puis le dispositif d'apport de colle (A), et enfin le dispositif de mise en place (B), ces dispositifs se succédant à chaque fois avec un intervalle comportant aussi peu de pas ou cycles que possible.

10. Composant semiconducteur à structure plane, fabriqué selon l'une quelconque des revendications 1 à 4, caractérisé en ce que le corps semiconducteur (11) et les fils de liaison (12) sont respectivement connectés directement à la surface en cuivre ou en alliage de cuivre de la bande de montage (1), et des conducteurs d'amenée.

## Claims

1. Process for manufacturing a planar semiconductor device, such that the rear side of a silicon substrate during mass production is contacted in electrically conductive manner to an assembly tape containing external leads, and which, in particular, contains copper or a copper alloy, and such that the contact pads on the front side of the semiconductor substrate are connected to the external leads via connecting wires, characterized in that the surface of said assembly tape (1), consisting of copper or a copper alloy, is submitted to reductive cleaning immediately prior to the attaching of the semiconductor substrate (11) and also of the connecting wires and that attaching of the connecting wires (12) to the contact pads (13) and to the assembly tape is effected by thermo compression bonding.

2. A process is claimed in claim 1, wherein said reductive cleaning is carried out in a hydrogen atmosphere.

3. A process is claimed in claim 2, wherein said reductive cleaning is carried out with the aid of a hydrogen flame.

4. A process is claimed in any one of claims 1 to 3, wherein said semiconductor substrate (11) is attached to said assembly tape (1) by way of cementing, soldering, or alloying.

5. A process is claimed in any one of claims 2 to 4, wherein ultrasonic waves are used additionally during both the attaching and contacting.

6. A process is claimed in any one of claims 1 to 5, wherein an assembly tape (1) provided with several finger-shaped leads is lead past a hydrogen flame, that immediately thereafter the rear side of said semiconductor substrate (11) is connected in an electrically conductive manner to the respectively provided surface of a lead, by way of cementing, and that the further finger-shaped leads as well as the aluminum contact pads (13) of said semiconductor substrate (11) are successively again subjected to a hydrogen flame, and that immediately thereafter gold wires are attached thereto by way of thermocompression bonding.

7. An appliance for carrying out the process as claimed in any one of claims 1 to 6, with said assembly tape being fed in a step-by-step manner to an adhesive-dispensing station as well as to a semiconductor substrate positioning station comprising a swivel arm with a suction pipette, wherein at one station (C) lying cycle steps ahead of said adhesive dispensing station (A), there is arranged an appliance (2) comprising a tube or pipe (3) with a parallel, vertically arranged tubular needle (4) as well as one tube (5) provided with an inclined arranged tubular needle (6), with said two tubular needles (4, 6) ending just over the surface of said assembly tape (1) as being led past them, within the area of said semiconductor substrate (11) to be contacted.

8. An appliance for carrying out the process as claimed in any one of claims 1 to 6, with the assembly tape being fed to a contacting station in a step-by-step manner, and a swivel arm carrying a capillary directed on to said assembly tape, wherein a gas-supply tube (15) is extending in parallel with said capillary (14) and ending up in a tubular needle (16) at the level of the opening of said capillary (14).

9. An appliance as claimed in claim 7 and 8, for carrying out the process as claimed in claim 6, wherein, in the direction of movement of said assembly tape (1) there is arranged at first the station (C) comprising the vertical (4) and the inclined tubular needle (6), which is followed by the adhesive-dispensing station (B) and finally by said contacting station (A) which are all arranged a small as possible number of cycle steps apart from each other.

10. Planar semiconductor device, manufactured as claimed in any one of the claims 1 to 4, wherein the semiconductor substrate (11) and the connecting wires (12) are contacted directly to the surface of the assembly tape (1) respectively of the leads, consisting of copper or a copper alloy.

# FIG. 2

# FIG.1

FIG. 3